# EUROPEAN PATENT SPECIFICATION

(11) **EP 2 390 093 B1**
(45) Date of publication and mention of the grant of the patent: **17.04.2013**
(21) Application number: 10172956.4
(22) Date of filing: 16.08.2010
(51) Int. Cl.: B32B 27/32, B32B 27/20, B32B 17/10, H01L 31/048

(54) **Polyolefin-based solar backsheet**
Polyolefinbasierte Rückseitenschicht für Solarmodule
Feuille arrière solaire à base de polyoléfine

(43) Date of publication of application: 30.11.2011
(73) Proprietor: 3M Innovative Properties Company, Saint Paul, MN 55133-3427 (US)
(72) Inventor: Graichen, Andreas, 40721 Hilden (DE); Schoeppel, Wolfgang, 41470 Neuss (DE); Juergens, Michael, 84524 Neuoetting (DE)
(74) Representative: Kurz, Arnd

(56) References cited:
- EP-A1- 1 898 470
- EP-A1- 1 956 660
- WO-A1-2010/053936
- WO-A2-99/04971
- DE-A1- 2 147 684
- JP-A- 2004 223 925
- US-A1- 2006 057 392
- US-A1- 2006 166 023
- US-A1- 2009 044 853

## Description

### Field

This disclosure relates to backsheets for solar modules, in particular, crystalline solar modules and to solar modules containing the backsheets and to methods of making the backsheets. The backsheets are based on poly-olefins selected from polyethenes (PE's) and polypropenes (PP's).

### Background

The use of solar cells has rapidly increased. The current solar cells can typically be classified into wafer-based solar cells (also referred to as crystalline solar cells or modules) and thin film solar cells or modules. Wafer-based solar cells contain crystalline silicon, for example monocrystalline silicon (c-Si), poly- or multi-crystalline silicon (poly-Si or mc-Si). They typically comprise a series of wafers soldered together, a so-called solar cell layer. The wafers are generally about 180 and about 240 µm thick. The solar cell layer may further comprise electrical wirings connecting the individual cell units and bus bars having one end connected to the cells and the other exiting the module. The solar cell layer is then further laminated to encapsulant layer(s) and protective layer(s) to form a weather resistant module. In general, a solar cell module derived from wafer-based solar cell(s) comprises, in order of position from the front light-receiving side to the back non-light-receiving side: (1) a top layer, (2) a top encapsulant layer, (3) a solar cell layer, (4) a back encapsulant layer, and (5) a backing layer. Instead of having separated top and back encapsulating layers there may also be just one encapsulating layer, which then incorporates the solar cell layer.

The top layer is typically a glass sheet. The encapsulant layers used in such solar cell modules are designed to encapsulate and protect the fragile solar cells and to adhere them to the top layer. Typical encapusulant layers include ethylene vinylacetates (EVA) polymers.

The backing layer typically contains a protective backsheet, which is a multi-layered protective material. The backsheet typically provides electrical insulation of the solar module and protects the solar module from influences from the environment, predominantly from moisture. Backsheets typically contain multiple layers from different materials, wherein each material and layer may serve a different purpose. Most commonly at least one of the materials contains a fluoropolymer. In addition to fluoropolymers frequently used materials include polyethene terephthalate (PET) polymers or polyethene naphthalate (PEN) polymers. This set up presents an economical disadvantage because the ingredients are comparatively expensive. In many cases tie layers or other additional ingredients may have to be provided to achieve sufficient cohesion of the individual layers to bond to each other and to the encapsulant layers of the solar module, which further increases costs. Other commercial types of backsheets comprise layers of polyester and/or polyamides. A disadvantage of many prior art materials is that the individual layers cannot be combined to a multi-layer backsheet in a single process step but instead have to be separately and subsequently bonded together, which further increases processing costs and may also lead to comparatively instable interlayer bonding in particular in view of long term stability requirements.

### Summary

In one aspect there is provided a multi-layered backsheet for solar modules as defined in the claims.

In another aspect there is provided a solar module comprising one or more solar cells and one or more encapsulating layer and further comprising said backsheet.

In a further aspect there is provided a method of making said backsheet. Said method is defined in the claims.

In yet another aspect there is provided a method of making a solar module comprising vacuum laminating said backsheet to a solar module.

### Brief Description of the Figures

Figure 1 is a schematic cross-sectional view of a photovoltaic module.
Figure 2 is a schematic cross-sectional view of an embodiment of the backsheet according to the present disclosure.
Figure 3 is a schematic cross-sectional view of an embodiment of the backsheet according to the present disclosure.
Figure 4 is a schematic cross-sectional view of an embodiment of the backsheet according to the present disclosure.
Figure 5 is a schematic cross-sectional view of an embodiment of the backsheet according to the present disclosure.
Figure 6 is a schematic cross-sectional view of an embodiment of the backsheet according to the present disclosure.
Figure 7 is a schematic cross-sectional view of an embodiment of the backsheet according to the present disclosure.
Figure 8 is a schematic cross-sectional view of an embodiment of the backsheet according to the present disclosure.
Figure 9 is a schematic cross-sectional view of an embodiment of the backsheet according to the present disclosure.
Figure 10 is a schematic cross-sectional view of an embodiment of the backsheet according to the present disclosure.

### Detailed Description

Before any embodiments of this disclosure are explained in detail, it is to be understood that the disclosure is not limited in its application to the details of construction and the arrangement of components set forth in the following description. The invention is capable of other embodiments and of being practiced or of being carried out in various ways. Also, it is to be understood that the phraseology and terminology used herein is for the purpose of description and should not be regarded as limiting.

As used herein, the terms "comprises," "comprising," "includes," "including," "containing," "characterized by," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus and including equivalents. Further, unless expressly stated to the contrary, "or" refers to an inclusive or and not to an exclusive or.

As used herein, the term "consisting of" is meant to be limiting and include only the specified materials or steps and their equivalents.

The use of "a" or "an" is meant to encompass "one or more".

Any numerical range recited herein is intended to include and to specifically disclose the end points specified and also all integers and fractions within that range. For example, a range of from 1% to 50% is intended to be an abbreviation and to expressly disclose the values 1 % and 50% and also the values between 1% and 50%, such as, for example, 2%, 40%, 10%, 30%, 1.5 %, 3.9 % and so forth.

The term "copolymer" is used to refer to polymers containing two or more monomers.

The present disclosure provides protective sheets for the back of solar modules, i.e. protective sheets for the side of a solar module that is opposite to its light-receiving side. Such sheets are referred to as backsheets. The present disclosure also provides solar modules comprising the backsheets and methods of making them.

The protective sheet materials (backsheets) provide electrical insulation. Typically, the backsheets have a dielectric breakdown voltage of at least 20 kV. The backsheets also provide mechanical protection of the solar module. Typically, the backsheets have an elongation at break of at least 50% and a tensile strength of at least 20 MPa. A particular advantage of the backsheets provided herein is that they provide long term electrical and mechanical protection against heat and moisture exposure. It has been found that the mechanical and electrical properties of the backsheets provided herein do not degrade or only degrade to a comparatively low degree after exposure to extreme heat and moisture conditions, like pressure cooking for 100 hours as described, for example, in the experimental section.

In one embodiment the backsheets have a total thickness of about 0,35 mm to about 0,70 mm, or from about 0,40 mm to about 0,65 mm. It is an advantage of the present disclosure that the backsheets with such a small thickness may already provide all or at least same of the properties described above and below.

The backsheets provided herein have a layered structure. When viewed from top (which is the side of the backsheet that is to be bonded to the solar module) it comprises the layers (i), (ii) and (iii) in this order. They may be or not be other layers covering the top of layers (i) or the back of layer (iii) or the top of layer (ii) in case the layer (i) is absent.

Layer (i) is referred to as the "top layer" and is an optional layer, although its presence is preferred.
Layer (ii) is referred to herein as an "insulating layer" by which is meant that this layer provides all or the major part of the electrical insulation of the backsheet. However, it is not meant that the other layers do not participate in providing electrical insulation, which in fact they may well do.
Layer (iii) is referred to herein as the "back layer". Its major purpose is to protect the layer (ii) from degradation.

The backsheets may be surface treated or at least one side of the backsheet may be surface treated. Surface treatment may be carried out to improve the compatibility or adhesion to another surface or to provide a functional or decorative pattern or structure.

The backsheets may have smooth or rough surfaces on one or both of its external sides. Rough surfaces may facilitate deaeration dunng the lamination process when the backsheet is included in a solar cell module. Rough surfaces can be created by mechanical embossing or by melt fracture during extrusion of the sheets followed by quenching so that surface roughness is retained during handling.

The layers (i), (ii) and/or (iii) contain polyethene (PE) polymers as their major component. "Major component" denotes that this component is present at the highest amount as expressed by percentage by weight based on the weight of the layer. The PE polymers are preferably present in an amount of greater than 50% by weight or even greater than 75% by weight or even greater than 90% by weight. The weight percentages are based on the weight of the layer they are contained in

Polyethene polymers (PE's) include homo- and copolymers of ethene, i e. polymers comprising repeating units *derived from ethene.

The PE polymers contain more than 50% by mole, preferably more than 60% by mole or more than 80% by mole and more preferably at least 95% by mole or more than 99% by mole or 100% by mole of units derived from ethene.

Comonomers include α-olefins such as but not limited to propene, 1-butene, 1-hexene, 1-octene and combinations thereof.

The PE polymers may have a melting point of at least 100°C. The PE polymers may be linear or branched. The PE polymers may also be graft polymers, blockpolymers, core-shell polymers or combinations thereof

Examples of suitable PE polymers include but are not limited to UHMWPE, HDPE, MDPE, LDPE, LLDPE, VLDPE. UHMWPE (ultra high molecular weight polyethene) is polyethylene polymer with a molecular weight greater than 1 x 10⁶ g/mole, usually between 3.1 and 5.67 million g/moles. It typically has a density of 0.930-0.935 g/cm³. HDPE (high density polyethene) is a polyethylene polymer having a density of greater or equal to 0 941 g/cm³ MDPE (medium density polyethene) is a polyethylene polymer having a density range of 0 926-0 940 g/cm³ LLDPE (linear low density polyethene) is a polyethylene polymer having a density range of 0.915-0.925 g/cm³. LDPE (low density polyethene) is a polyethene polymer having, a density range of 0 910-0.940 g/cm³ VLDPE (very low density polyethene) is a polyethene polymer having a density range of 0.880-0 915 g/cm³. It has been found that not only polymers of the same architecture (e.g. only branched or only linear polymers) may be used but also polymers of different structures, like, linear and non-linear polymers, may be used in the backsheets provided herein. For example one layer may be prepared by a linear material, like HDPE and another layer may be prepared by a non-linear material like LDPE.

Polyethenes are inexpensive raw materials. Therefore, it is an advantage of the backsheets provided herein that they can be prepared at low raw material costs Yet the backsheet has the desired mechanical properties like elongation at break and/or tensile strength, electrical insulation and/or long-term stability under moisture and heat as described herein. Another advantage of the present backsheets is that several or even all of their layers can be prepared in principle from the same or at least the same type of polymeric material (i.e. polyethene polymers). This means the layers can be prepared from materials having the same or similar chemical composition and/or rheology, such as viscosity or density. Similar in this respect means a deviation of less than 10% This increases the compatibility of the layers with each other such that tie-layers, primer or adhesive layers are not required to provide sufficient bonding of the individual layers. Instead the layers are prepared by co-extrusion which obviates the use of adhesives and the like. Using co-extrusion the backsheets or major components (layers) thereof can be prepared in a single process step For example, the layers (i) and (ii) on (ii) and (iii) or (i), (ii) and (iii) may be coextruded simultaneously Therefore, there are no other layers between layers (i), (ii) and (iii). In such embodiments the respective layers may form a continuous common interface

Therefore, another advantage of the present disclosure is that a backsheet having some or all of the properties described herein may be prepared without requiring layers from other polymers or other materials

The PE polymers in layers (i) and/or (ii) and/or (iii) are in cross-linked form in the assembled back sheet but may be used in non-cross-linked form in the preparation of the backsheet. The layers may be prepared by non-cross-linked polymers but may be cross-linked afterwards either individually or combined. For example layer (ii) and (iii) together or layers (i) and (ii) or, preferably layers (i), (ii) and (iii) are subjected to cross-linking. The cross-linking may be carried out chemically or physically, the latter being preferred. In chemical cross-linking the composition contains a cross-linker as described below. The cross-linker may be activated thermally, by chemical reaction or by irradiation, typically UV irradiation. In physical cross-linking the cross-linking is achieved by irradiating the polymers with γ- or β-irradiation or e-beam irradiation. A cross-linking agent is not required and may not be present. Preferably, the cross-linking is carried out by bulk irradiation of all layers (i.e. (ii) and (iii) or (i), (ii) and (iii).
The layers may be cross-linked by the same or different cross-linking methods or cross-linkers and may be subjected by the same cross-linking process together or separately. A combination of physical and chemical crosslinking may also be used.

In one embodiment the layers (i), (ii) and (iii) all contain as a major component a polyethene polymer containing more than 75% by mole or more than 85% by mole or more than 95% by mole of units derived from ethene. The layers are preferably cross-linked, for example by physical cross-linking, like but not limited to e-beam irradiation.

The combination of the layers (i), (ii) and (iii) or the individual layers (i), (ii) and (iii) may have a thickness effective to provide the electrical breakdown voltage of at least 20 kV and / or some or all of the mechanical properties as described herein. Typically a thickness of at least 210 µm or at least 310 µm may be sufficient.

The individual layers of the backsheet will now be described in greater detail.

### Top layer (layer (I)):

The top layer is an optional layer. It is positioned at the top of the backsheet, i.e. the position which is to contact the encapsulant layer of the solar module or a surface of a layer or a plurality of layers covering it - for example adhesive layers or tie layers if required. More specifically, it is to contact the encapsulant layer that is opposite to the light-receiving side of the solar module (or a layer a surface of layer or a plurality of layers covering it). However, layer (i) may be covered on its top face by other layers, for example intermediate layers as described below. The layer may or may not be surface treated to provide a surface pattern or structure or to roughen the surface as described above.
The top layer, if present, may be of the same polymer composition as layer (ii) or (iii) or of a different composition.

A top layer (i) may be desired, for example, to introduce a colour into the solar module or the backsheet or a coloured pattern representing information or decoration. Such colour or pattern can be introduced by printing it onto the top layer or by using a top layer containing pigments or a combination of pigments. In a preferred embodiment, the top layer (i) contains white pigments and/or reflective particles. In this embodiment the top layer (i) may be of white colour. It may also be non transparent. Having such a top layer (i) may increase the efficiency of the solar module by reflecting light and it may also or alternatively protect the layer (ii) from degradation by preventing or hindering light and/or UV irradiation to travel through to layer (ii).

Therefore, the top layer is typically coloured or contains at least pigments. Typical pigments include inorganic pigments, preferably white pigments. Typical examples of white pigments include titanium oxides, like but not limited to TiO₂ or zinc oxides, like but not limited to ZnO, or combinations thereof. Other pigments include pigments for green, red and blue. The layer may contain up to 1% by weight up to 4% by weight or up to 20% by weight of pigments or reflective particles. Preferred reflective particles are reflective glass particles.

The top layer may in addition to the pigments also contain UV-stabilisers, for example those described below.
The top layer may in addition to the pigments also contain antioxidants, for example those described below.

The top layer may in addition to the pigments also contain cross-linking agents for example those described below

The top layer may in addition to the pigment also contain flame retardants for example those described below.

The top layer may in addition also contain anti-dripping agents, for example those described below.

The top layer may typically have a thickness of from about 10 µm to about 150 µm, or from about 50 µm to about 100 µm

The top layer contains a cross-linked PE polymer

The top layer may form a continuous interface with the insulating layer (ii).

### Insulating layer (layer (ii)):

The insulating layer may be the top outmost layer of the backsheet, in case there is no top layer (i) and in case of the backsheet is not attached to the solar module The layer may or may not be surface treated to create a pattern or structure or roughened surface as described above If incorporated into a solar module the insulating layer may in this case be in direct contact with the back encapsulant layer of the solar module or it may be separated therefrom by one or more intermediate layers" for example optional intermediate layers, or adhesive layers and the like. If a top layer (i) is present the layer (ii) is placed between layer (i) and above layer (iii)

The insulating layer has sufficient thickness to provide a dielectric breakdown voltage of the backsheet of at least 20 kV The optimum thickness depends on the chemical composition of the layer. Typically the layer has a thickness of at least 210 µm or at least 310 µm or at least 350 µm. The upper limit of the layer is determined by material costs and the mechanical properties of the backsheet but typically is less than 1,000 µm.

The insulating layer typically, comprises the PE polymers described above. The polymer is cross-linked. The chemical composition of layer (ii) may be identical or that of layer (iii) and identical or different to that of (i). The rheological property of layer (ii), for example its viscosity and/or density may be identical or different to that of layer (i) and/or (iii).
The layer (ii) may contain, for example, up to about 10 wt %, preferably up to about 5 wt %, and more preferably up to about 1 wt % of anitoxidants based on the total weight of the layer. In addition or instead of antioxidants the layer may contain, for example, up to about 10 wt %, preferably up to about 5 wt %, and more preferably up to about 1 wt % of UV-stabilizers based on the total weight of the layer.
In addition or instead of antioxidants and/or UV-stabilizers the layer (ii) may contain anti-dripping agents like those described below. Typical amounts include up to 1% wt, or up to %wt or up to 10% wt based on the weight of the layer.

Preferably, the layer (ii) does not contain carbon particles (because this may reduce the insulating properties of the layer).
Preferably, layer (ii) does not contain organic or inorganic pigments. Preferably, layer (ii) does not contain carbon particles and pigments. Thus, in one embodiment, layer (ii) is free of pigments as those described below. Preferably, layer (ii) is free of carbon particles or free of carbon particles and pigments. "Free of" as used herein means from 0 to less than 1% wt or from 0 to less than 0.1 % wt or from 0 to less than 0.01 % wt based on the weight of the layer or 0% (within the detection limit).

More preferably, layer (ii) does not contain any additives other than flame retardants and anti-oxidants as described below.
It has been found that layer (ii) can contain up to 35% or up to 30% by weight based on the weight of the layer of flame retardant and yet has a dielectric break down voltage of at least 20 kV. Therefore, layer (ii) may contain up to 35 or up to 30% or up to 20% or up to 10% by weight based on the weight of the layer of flame retardants.
In addition or instead of the above the layer may also contain anti-dripping agents.

Therefore, another advantage of the backsheets provided herein is that they can be loaded to up to 20% or up to 30% by weight per layer with flame retardants or flame retardants and anti-dripping agents and thus has a good anti-burning behaviour but may still provide the mechanical, electrical and heat and moisture properties described herein.

### Back layer (layer (iii)):

This layer protects the layer (ii) from the environment. It may contain the same or a different polyolefin than layer (ii). Layer (iii) typically contains carbon particles The carbon particles may be modified, for example surface treated, coated or may contain functionalised groups (e g by chemical reaction with chemical modifiers or by adsorption of chemicals) Carbon particles include graphite, fullerenes, nanotubes, soot, carbon blacks (e.g, carbon black, acetylene black, ketjen black) Typically, the layer (iii) may contain from about 1% to about 6% or up to about 10% weight based on the weight of the layer of carbon particles The loading with carbon particles may be increased but in that case the layer may become election conductive In this case the layer may have to be earthed when it is incorporated into a solar module.

Typically, layer (iii) is of black colour due the presence of substantial amounts of carbon particles. However, the layer can be of a different colour if pigments or paints are used.

In addition or as alternative to the carbon particles layer (iii) may contain other additives Such additives include antioxidants, for example those described below. Other additives include UV-absorbers, for example those described below, cross-linkers as described below and flame retardants, like, those described below and anti dripping agents The amount of these ingredients may be individually or combined be from about 1%wt to up to 10% wt.

Typically, the layer (iii) may have a thickness of about 50 to about 100 µm

The layer (m) is in direct contact with layer (ii). Preferably, it forms a continuous interface with layer (ii). This means that no tie-layer, primer or adhesive is placed between layer (ii) and (iii).

Layer (iii) comprises a cross-linked PE polymer . The layer (iii), however, may be prepared by non-cross linked polymers and are cross-linked during or after assembly

It has been found that layer (m) can contain up to 35% or up to 30% by weight based on the weight of the layer of flame retardant and yet the backsheet has a dielectric break down voltage of at least 20 k\/, when using the layer (ii) as described above. Therefore, layer (iii) may contain up to 35 or up to 30% or up to 20% or up to 10% by weight based on the weight of the layer of flame retardants.

In one embodiment layer (ii) and (iii) may each contain up to 10% or up to 20% or even up to 30% by weight of flame retardants based on the weight of the respective layer

### Optional layers (iv), (v), (vi):

One or more optional layers may be introduced into the backsheet to introduce further desirable properties or to enhance the existing properties.

For example coloured layers or layers containing patterns displaying decoration or information may be introduced to the backsheet by introducing optional layers (iv), for on top of layer (ii) in case layer (i) is absent or on the back of layer (iii): Such coloured layers may contain the polyolefins as described above and pigments or pattern displaying information or decoration printed thereon or introduced into the surface of that layer by surface-treatment

In one embodiment the optional layer (iv) is a polyolefin layer and contains the same polyolefin as layer (ii), or as layer (iii) or as layer (ii) and (iii). Optional layer (iv) may typically have a thickness of from about 5 to about 100 µm

To further reduce the vapour transmission rates a metal layer (v), for example a metal foil, like an aluminium foil, may be incorporated into the backsheet. It may be possible to provide the metal foil on the back of layer (iii), i.e facing away from layer (ii). In this case the metal foil would,be covered by one or more additional layers, with may also be a polyolefinic layer containing polyolefins as described above to protect the metal film from deterioration by weather and,environment The thickness of this optional layer (v) may be in the range of 5 - 100 µm based on the type of material used.

Another optional intermediate layer includes one or more external protection layers (vi). The protection layer faces the back side of the backsheet on its one side and the environment on its opposite side If incorporated it may be exposed to the environment from the non-light-receiving side of the solar module This layer may comprise polyurethanes, polyarylates, silicones and combinations thereof, or it may contain the polyolefins like those used in layers (i), (ii) or (iii) as described above. It may contain additives which further increase the UV stability, thermal stability and resistance to oxidation or corrosion. It may contain flame retardants or it may provide anti-scratch properties or easy-to-clean properties. It may also be a coloured layer to provide the outside of the backsheet with another colour than black.

The thickness of this layer may typically be in the range of 1 - 500 µm based on the type of material used.
If materials other than polyolefins need to be applied as the outermost layer it is likely that the surface energy of the outer polyolefin layer has to be increased by appropriate surface modification methods (corona treatment and the like) to achieve the required adhesion. Alternative methods include the use of adhesives, primers or tie layers.

One or more scrim or net layers may also be present to further increase dimensional stability and handling properties. Scrim or net type layers may also improve the anti dripping performance during burning. Scrim or net layers are net-shaped layers of a polymeric or plastic material.

### Cross-Linker:

Chemical cross-linking agents may be activated thermally or by irradiation. Typical chemical cross-linking agents include vinyl-silanes, such as but not limited to vinyl-tri-ethoxy or vinyl trimethoxy silane. They may be blended or copolymerised with the PE polymers. Other types of chemical cross-linkers include radical cross-linker which decompose to generate radicals. These radical then lead to a cross-linking reaction. Examples include but are not limited to peroxides and azo-compounds. Examples for cross-linkers activated by irradiation include but are not limited to benzophenones. Typically, the cross-linkers are dispersed in the PE polymers or blended with them.

### Anti-oxidants:

Anti-oxidants can be chosen from a wide range of known anti-oxidants that are compatible with polyolefins. Examples include but are not limited to phenolic or phosphitic anti-oxidants, such as alkylated monophenols, alkylthiomethylphenols, hydroquinones, alkylated hydroquinones, tocopherols, hydroxylated thiodiphenyl ethers, alkylidenebisphenols, acylaminophenols. Other examples include but are not limited to O-, N- and S-benzyl compounds, hydroxybenzylated malonates, aromatic hydroxybenzyl compounds, triazine compounds, aminic antioxidants, aryl amines, diaryl amines, polyaryl amines, oxamides, metal deactivators, phosphites, phosphonites, benzylphosphonates, ascorbic acid (vitamin C), compounds which destroy peroxide, hydroxylamines, nitrones, benzofuranones, indolinones, and the like and mixtures thereof. More preferably, the antioxidant is a member of the class of bis-phenolic antioxidants. Suitable specific bis-phenolic antioxidants include 2,2'-ethylidenebis(4,6-di-t-butylphenol); 4,4'-butylidenebis(2-t-butyl-5-methylphenol); 2,2'-isobutylidenebis(6-t-butyl-4-methylphenol); and 2,2'-methylenebis(6-t-butyl-4-methylphenol). Some commercially available bis-phenolic antioxidants include ANOX 29, LOWINOX 22M46, LOWINOX 44B25, and LOWINOX 221 B46.

### UV-absorbers:

Typical examples of UV absorbers include but are not limited to triazines, benzotriazoles, hydroxybenzophenones, hydroxyphenyltriazines, esters of benzoic acids, and mixtures of two or more thereof. Further examples include cyclic amines. Examples include secondary, tertiary, acetylated, N-hydrocarbyloxy substituted, hydroxy substituted N-hydrocarbyloxy substituted, or other substituted cyclic amines which are further characterized by a degree of steric hindrance, generally as a result of substitution of an aliphatic group or groups on the carbon atoms adjacent to the amine function.

### Flame retardants:

Flame retardants are compounds the reduce or prevent flame propagation or increase the inflammability of a material. Examples of flame retardants include but are not limited to halogenated aromatic compounds, like halogenated biphenyls or biphenyl ethers and bisphenols. Typically the halogenated materials are brominated or polybrominated. Specific examples include bisphenols like polybrominated biphenyl, penta-, octa and deca deca-brominated diphenyl ethers (BDE's), tetrabromobisphenol-A (TBBPA).

Further examples include but are not limited to inorganic compounds like alumina trihydrate, antimony oxide, magnesium hydroxide, zinc borate, organic and inorganic phosphates, red phosphor and combinations thereof.

### Anti-Dripping Agents:

Anti-dripping agents are substances that reduce or prevent dripping of a polymer when being exposed to a flame. Typically, dripping agents include fluoropolymers, such a polytetrafluoroethene polymers and copolymers. The dripping agents may be dispersed in or blended with the polymer making up the respective layer. Commercial examples of dripping agents include MM5935EF from Dyneon LLC, ALGOFLON DF210 from Solvay-Solexis or ENTROPY TN3500 from Shanghai Entropy Chemical.

### Pigments and reflective materials:

Pigments may be inorganic or organic. Pigments may be of green, blue, red, pink, purple and white colour. Most commonly used white pigments are inorganic pigments. Examples include but are not limited to zinkoxides and titanium oxides (like TiO₂). The pigments may be dispersed, blended or dissolved in the layer but may be painted or printed onto a layer.

Carbon particles are not pigments in the meaning of this disclosure.

Reflective materials include glass particles or metal particles, with glass particles being preferred. They may be dispersed, blended or dissolved in a layer.

The backsheets are now further illustrated by referring to the figures.

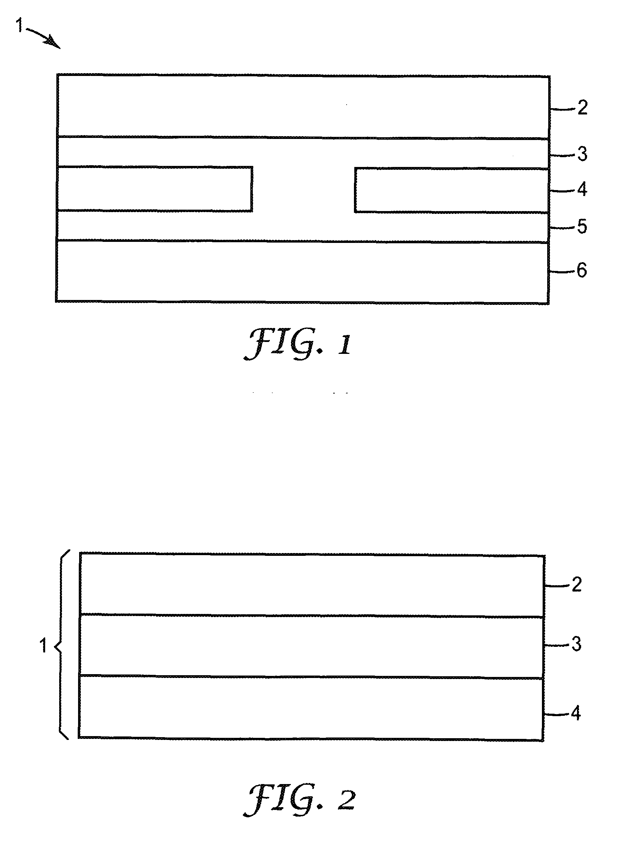

Figure 1 shows a schematic cross-section of a solar module (1). The solar module (1) contains a light-receiving side (2) (the top side) and a side (6) that is opposite to the light receiving side, which is the back side. Between the top and the back side there is a cell layer comprising an array of interconnected solar cells, i.e., devices that convert light into electrical energy. The solar cell layer including its connectors is represented in figure 1 by layer (4). The solar cell layer is encapsulated by one or more encapsulating layers (2) and (5). Instead of two separate layers (2) and (5) a single encapsulating layer may be used which then incorporates the solar cell layer (4).

The back side (6) typically contains a backsheet to protect the interior of the module from the environment.

Figures 2 to 10 show various embodiments of the backsheets provided herein.
Figure 2 is a schematic representation of a cross-section of a backsheet (1) as prepared in example 1. It contains a top layer (i) represented by layer (2) in figure 2 which will face the encapsulant layer of the solar module (e.g. a layer (5) of figure 1) if incorporated into the solar cell. The backsheet (1) further contains a middle layer (insulating layer) (ii) represented by layer (3) in figure 2 and a back layer (iii) represented by layer (4) in figure 2. The top layer (i) is white and contains HDPE and white pigments. Layer (iii) is black and contains HDPE and carbon black. The layer (ii) contains LDPE. All three layers contain UV stabilisers and have been coextruded, which means that layer (i) and (ii) and layer (ii) and (iii) form a continuous common interface. All layers have been subjected to a cross-linking treatment, which means that the polymers of the individual layers are cross-linked. The cross-linking treatment was carried out by bulk cross-linking which means that also the neighbouring layers (i.e. layers (2) and (3) and/or (3) and (4)) may be cross-linked with each other.

The layers (i), or layer (ii) and/or layer (iii) may additionally contain UV stabilisers. They may also contain flame retardants and/or anti-dripping agents. They may also contain, although less preferred, cross-linker either as individual compounds or as comonomers. Layers (i) and/or (iii) may further contain antioxidants.

The multi-layer construction may also contain incorporated or added on top of (i) or to the back of (iii) or both a scrim layer.

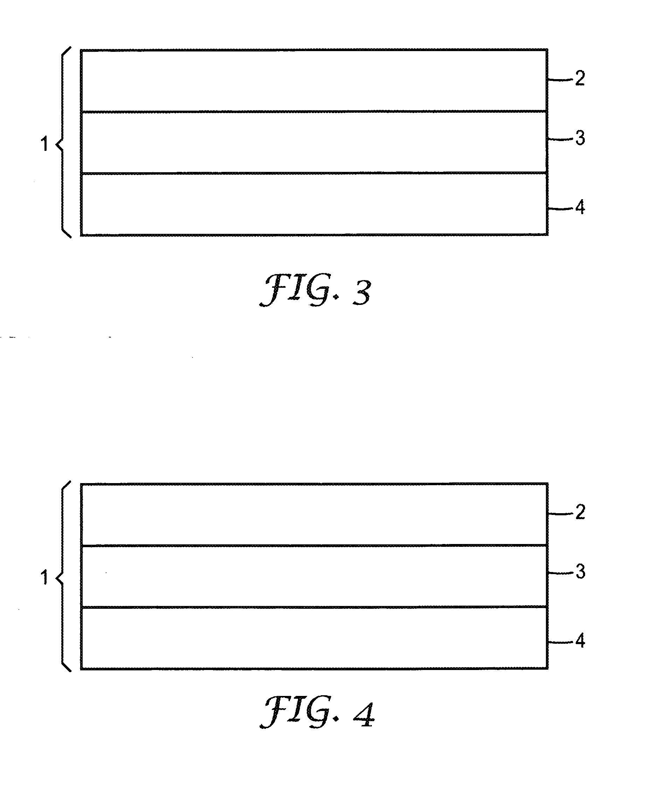

In figure 3 a schematic cross section of another embodiment of a backsheet (1) is shown. The backsheet (1) contains a top layer (i) of HDPE (which may contain pigments, in particular white pigments) and is represented by (2). The insulating layer (ii) represented by (3) also contains HDPE. Layer (3) does not contain pigments but may contain flame retardants and/or anti-dripping agents. Back Layer (iii) represented by layer (4) also contains HDPE and carbon particles. Layer (4) is black. Layer (4) may further contain flame retardants and/or anti-dripping agents and other additives like antioxidants, UV stabilisers and cross-linker. All three layers have been coextruded, which means that layers (i) and (ii) and layers (ii) and (iii) form a continuous common interface. In one embodiment all layers have been subjected to a cross-linking treatment, which means that the polymers of the individual layers are cross-linked. The cross-linking treatment may be carried out by bulk cross-linking which means that also the neighbouring layers (i.e. layers (2) and (3) and/or (3) and (4)) may be cross-linked with each other.

The layer (i) may additionally contain flame retardants or cross-linker either as individual compounds or as comonomers and/or may contain contain antioxidants, UV stabilisers, flame retardants and anti-dripping agents.

The multi-layer construction may also contain incorporated or added on top of (i) or to the back of (iii) or both a scrim layer.

In figure 4 a schematic cross section of another embodiment of a backsheet (1) is shown. The backsheet (1) contains a top layer (i) of LDPE (which may contain pigments, in particular white pigments) and is represented by (2). The insulating layer (ii) represented by (3) also contains LDPE. Layer (3) does not contain pigments but may contain flame retardants and/or anti-dripping agents and/or UV stabilisers. Layer (iii) represented by layer (4) also contains LDPE and carbon particles. Back Layer (4) is black. Layer (4) may further contain flame retardants and/or anti-dripping agents. All three layers have been coextruded, which means that layer (i) and (ii) and layer (ii) and (iii) form a continuous common interface. In one embodiment all layers have been subjected to a cross-linking treatment, which means that the polymers of the individual layers are cross-linked. The cross-linking treatment was carried out by bulk cross-linking which means that also the neighbouring layers (i.e. layers (2) and (3) and/or (3) and (4)) may be cross-linked with each other.

The layer (i) may additionally contain flame retardants and/or anti-dripping agents, or cross-linker either as individual compounds or as comonomers. Layers (i) and/or (iii) may further contain antioxidants and/or UV stabilisers.

The multi-layer construction may also contain incorporated or added on top of (i) or to the back of (iii) or both a scrim layer.

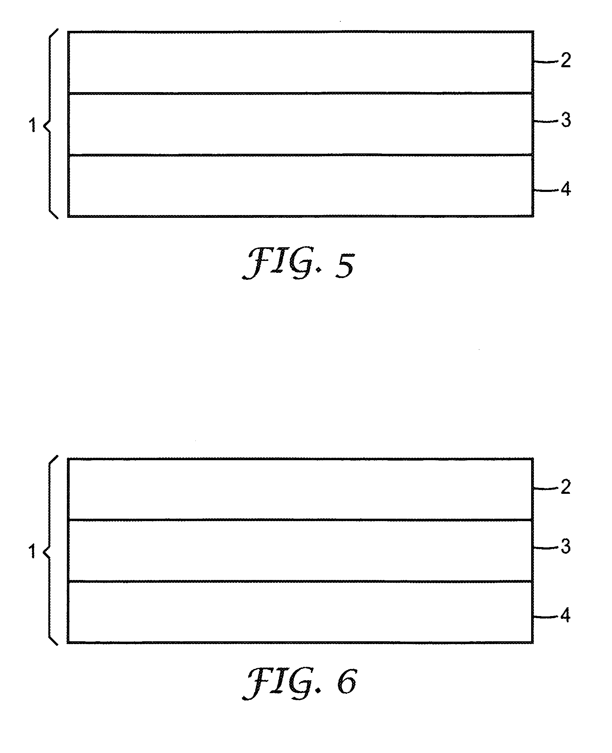

In figure 5 a schematic cross section of another embodiment of a backsheet (1) is shown. The backsheet (1) contains a top layer (i) of LDPE (which may contain pigments, in particular white pigments) and is represented by (2). The insulating layer (ii) represented by (3) also contains HDPE. Layer (3) does not contain pigments but may contain flame retardants and/or anti-dripping agents. Back Layer (iii) represented by layer (4) also contains LDPE and carbon particles. Layer (4) is black. Layer (4) may further contain flame retardants and/or anti-dripping agents. All three layers have been coextruded, which means that layer (i) and (ii) and layer (ii) and (iii) form a continuous common interface. In one embodiment all layers have been subjected to a cross-linking treatment, which means that the polymers of the individual layers are cross-linked. The cross-linking treatment may be carried out by bulk cross-linking which means that also the neighbouring layers (i.e. layers (2) and (3) and/or (3) and (4)) may be cross-linked with each other.
The layer (i) may additionally contain flame retardants and/or anti-dripping agents, or cross-linker either as individual compounds or as comonomers. Layers (i) and/or (iii) may further contain antioxidants and/or UV stabilisers.

The multi-layer construction may also contain incorporated or added on top of (i) or to the back of (iii) or both a scrim layer.

In figure 6 a schematic cross section of another embodiment of a backsheet (1) is shown. The backsheet (1) contains a top layer (i) of LDPE (which may contain pigments, in particular white pigments) and is represented by (2). The insulating layer (ii) represented by (3) also contains HDPE. Layer (3) does not contain pigments but may contain flame retardants and/or anti-dripping agents. Back Layer (iii) represented by layer (4) also contains LDPE and carbon particles. Layer (4) is black. Layer (4) may further contain flame retardants and/or anti-dripping agents. All three layers have been coextruded, which means that layer (i) and (ii) and layer (ii) and (iii) form a continuous common interface. In one embodiment all layers have been subjected to a cross-linking treatment, which means that the polymers of the individual layers are cross-linked. The cross-linking treatment may be carried out by bulk cross-linking which means that also the neighbouring layers (i.e. layers (2) and (3) and/or (3) and (4)) may be cross-linked with each other.

The layer (i) may additionally contain flame retardants and/or anti-dripping agents, or cross-linker either as individual compounds or as comonomers. Layers (i) and/or (iii) may further contain antioxidants and/or UV stabilisers.

The multi-layer construction may also contain incorporated or added on top of (i) or to the back of (iii) or both a scrim layer.

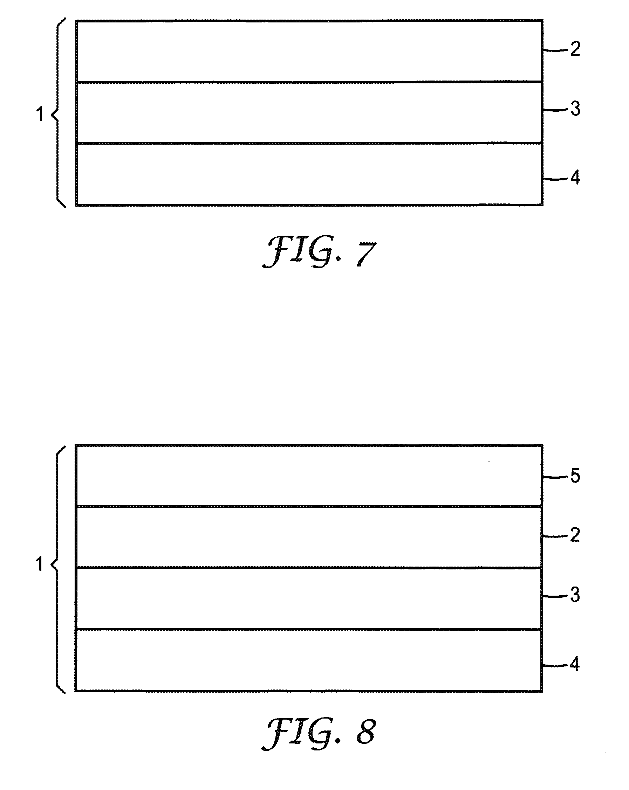

In figure 7 a schematic cross section of another embodiment of a backsheet (1) is shown. The backsheet (1) contains a top layer (i) of HDPE (which may contain pigments, in particular white pigments) and is represented by (2). The insulating layer (ii) represented by (3) also contains HDPE. Layer (3) does not contain pigments but may contain flame retardants and/or anti-dripping agents. Back Layer (iii) represented by layer (4) contains LDPE and carbon particles. Layer (4) is black. Layer (4) may further contain flame retardants and/or anti dripping agents. All three layers have been coextruded, which means that layer (i) and (ii) and layer (ii) and (iii) form a continuous common interface. In one embodiment all layers have been subjected to a cross-linking treatment, which means that the polymers of the individual layers are cross-linked. The cross-linking treatment may be carried out by bulk cross-linking which means that also the neighbouring layers (i.e. layers (2) and (3) and/or (3) and (4)) may be cross-linked with each other.

The layer (i) may additionally contain flame retardants or cross-linker either as individual compounds or as comonomers. Layers (i) and (iii) may further contain antioxidants and UV stabilisers.

The multi-layer construction may also contain incorporated or added on top of (i) or to the back of (iii) or both a scrim layer.

In figure 8 a schematic cross section of another embodiment of a backsheet (1) is shown. The backsheet (1) contains a top layer (i) represented by (2), an insulating layer (ii) represented by (3) and a back layer (iii) represented by layer (4). Layers (i), (ii) and (iii) may be as described herein or as shown in figures 2 to 7. The embodiment shown in figure 8 further contains an optional layer (iv) represented by (5). The embodiment may further contain one or more scrim layers.

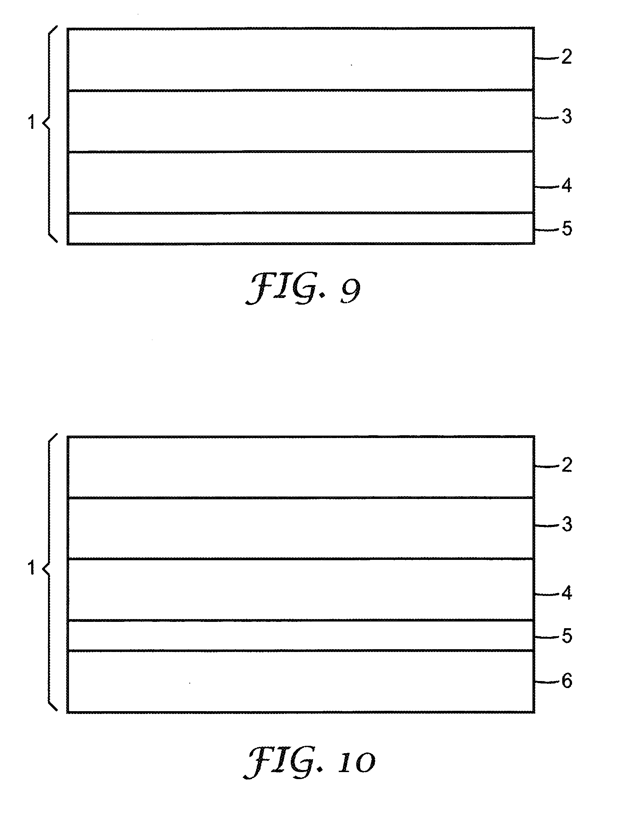

In figure 9 a schematic cross section of another embodiment of a backsheet (1) is shown. The backsheet (1) contains a top layer (i) represented by (2), an insulating layer (ii) represented by (3) and a back layer (iii) represented by layer (4). Layers (i), (ii) and (iii) may be as described herein or as shown in figures 2 to 8. The embodiment shown in figure 9 further contains an optional layer (vi) represented by (5). The embodiment may also contain one or more scrim layers.

In figure 10 a schematic cross section of another embodiment of a backsheet (1) is shown The backsheet (1) contains a top layer (i) represented by (2), an insulating layer (ii) represented by (3) and a back layer (iii) represented by layer (4) Layers (i), (ii) and (iii) may be as described herein or as shown in figures 2 to 7. The embodiment shown in figure 10 further contains an optional layer (v) represented by (5) and at least one external protective layer (vi) represented by (6). The embodiment may also contain one or more scrim layers.

### Methods of making backsheets:

The backsheets can be produced by any suitable process For example, a pre-formed multi-layer sheet may be produced by first separately preparing each of the component layer sheets through any suitable process and then laminating or bonding the layers to form the multi-layer sheet The layers may also be glued together However, it is an advantage of the present backsheets that they can be produced directly by a co-extrusion process or that at least some of their layers can be produced by co-extrusion. The layers (ii) and (iii) or layers (i) and (ii) or (i), (ii) and (iii) are coextruded. For co-extruston the compositions making up the layers are prepared by mixing the ingredients. The compositions are then extruded in molten form through the respective sheet-shaping dies In case of coextrusion the dies and feedblocks are shaped such that the extrudates leaving the dies form the multilayered article upon cooling. The compositions can generally be extruded at a temperature of about 160 °C to about 280°C Other than allowing the fabrication of the backsheet in a single step, coextruded layers also have the advantage of being more homogenous and contain fewer air bubble inclusions and or particle inclusions This may further increase the electrical properties and long-term performance of the backsheets The coextrusion may also be carried out by cast film extrusion or blown film extrusion

After coextrusion, the layers may be cross-linked individually or combined as described above Preferably, the layer (i), (ii) and (iii) are combined and then cross-linked simultaneously.

### Solar modules:

The invention further provides a solar cell module comprising at least one backsheet as described above.

A solar module comprises at least one solar cell layer. The solar cells have a light-receiving side and a side opposite to it, which is referred to as the non-light-receiving side. Preferably, the solar cells are electrically interconnected and/or arranged in a flat plane. In addition, the solar cell layer may further comprise electrical wirings, such as cross ribbons and bus bars.

The term "solar cell" is meant to include any article which can convert light into electrical energy. Preferred are wafer-based solar cells (e.g., c-Si or mc-Si based solar cells).

The solar module further contains one or more encapsulant layers.The solar module contains at least one encapsulant layer or a part of an encapsulant layer adjacent to the non-light-receiving side of the solar cell layer. Thus this encapsulant layer also has a light-receiving side which is the part of the layer facing the non-light-receiving side of the solar cells and a non-light-receiving side, which is the part opposite to its light-receiving part.

The backsheet is laminated to the non-light-receiving part of the encapsulant layer (or part thereof) facing the non light-receiving side of the solar cells. This encapsulant layer may comprise any suitable polymeric material. Some specific examples of such polymeric materials include acid copolymers, ionomers, poly(ethylene vinyl acetates), poly(vinyl acetals), polyurethanes, poly(vinyl chlorides), polyethylenes (e.g., linear low density polyethylenes), polyolefin block elastomers, copolymers of an α-olefin and an α,β-ethylenically unsaturated carboxylic acid ester (e.g., ethylene methyl acrylate copolymer and ethylene butyl acrylate copolymer), silicone elastomers, epoxy resins, and combinations of two or more thereof. Preferably, the encapsulant layer comprises poly(ethylene vinyl acetates)(EVA).

The solar cell module may further comprise an incident layer serving as the outermost layer(s) of the module at the light-receiving side. The outermost layers may be formed of any suitable transparent sheets or films. Suitable sheets may be glass or plastic sheets, such as polycarbonates, acrylic polymers (i.e., thermoplastic polymers or copolymers of acrylic acid, methacrylic acid, esters of these acids, or acrylonitrile), polyacrylates, cyclic polyolefins (e.g., ethylene norbornene polymers), polystyrenes (preferably metallocene-catalyzed polystyrenes), polyamides, polyesters, fluoropolymers, or combinations of two or more thereof. Typically, the outmost layers are made of glass. The term "glass" includes not only window glass, plate glass, silicate glass, sheet glass, low iron glass, tempered glass, tempered CeO-free glass, and float glass, but also colored glass, specialty glass (such as those types of glass containing ingredients to control solar heating), coated glass (such as those sputtered with metals (e.g., silver or indium tin oxide) for solar control purposes), E-glass, Toroglass, SOLEX glass (PPG Industries, Pittsburgh, Pa, USA.) and STARPHIRE glass (PPG Industries). It is understood, however, that the type of glass to be selected for a particular module depends on the intended use.

The solar cell module may further comprise other functional film or sheet layers (e.g., dielectric layers or barrier layers) embedded within the module, although this may not be required. Such functional layers may comprise polymeric films that are coated with additional functional coatings. For example, poly(ethylene terephthalate) films coated with a metal oxide coating may function as additional oxygen and moisture barrier layers in the modules but are not required. In one embodiment the solar module or the backsheet do not contain such a barrier film.

If desired, a layer of nonwoven glass fiber (scrim) may also be included between the solar cell layers and the encapsulant layers to facilitate deaeration during the lamination process or to serve as reinforcement for the encapsulants.

If desired a surface of the encapsulant layer may be treated prior to the lamination process to incorporate the backsheet to enhance the adhesion of the backsheet to the encapsulant layer. This adhesion enhancing treatment may take any form known within the art and may include flame treatments, plasma treatments, electron beam treatments, oxidation treatments, corona discharge treatments, chemical treatments, chromic acid treatments, hot air treatments, ozone treatments, ultraviolet light treatments, sand blast treatments, solvent treatments, and combinations of two or more thereof. However, it is an advantage of the backsheets provided herein that they can be satisfyingly bonded to the encapsulant layer, in particular when the encapsulant layer contains EVA, by lamination, in particular vaccuum lamination.

Solar modules may be prepared by stacking the component layers of the solar cell module in a desired order to form a pre-lamination assembly. The assembly may then placed into a bag capable of sustaining a vacuum ("a vacuum bag"), the air is drawn out of the bag by a vacuum line or other means, the bag is sealed while the vacuum is maintained and the sealed bag is placed in an autoclave at a pressure and temperature sufficient to provide lamination. A vacuum ring may be substituted for the vacuum bag. Following the heat and pressure cycle, the air in the autoclave may be cooled without introducing additional gas to maintain pressure in the autoclave. The excess air pressure is vented and the laminates are removed from the autoclave.

Alternatively, the pre-lamination assembly may be heated in an oven after which the heated assembly is passed through a set of nip rolls so that the air in the void spaces between the individual layers may be squeezed out, and the edge of the assembly sealed. The assembly at this stage is referred to as a pre-press. The pre-press may then be placed in an air autoclave subjected to an appropriate temperature and pressure regime to achieve laminated products.

The solar cell modules may also be produced through non-autoclave processes. Generally, the non-autoclave processes include heating the pre-lamination assembly and the application of vacuum, pressure or both. For example, the assembly may be successively passed through heating ovens and nip rolls.

If desired, the edges of the solar cell module may be sealed. Suitable materials useful in sealing the solar cell module edges include, but are not limited to, butyl rubber, polysulfide, silicone, polyurethane, polypropylene elastomers, polystyrene elastomers, block elastomers, styrene-ethylene-butylene-styrene (SEBS), and the like. It is another advantage of the backsheets provided herein that they are compatible with the sealants described above and can thus provide good sealing of the interface of the backsheet and encapsulant layer of the solar module.

The following list of exemplary embodiments illustrates various specific features, advantages, and other details of the invention. The particular materials and amounts recited in these exemplary embodiments, as well as other conditions and details, should not be construed in a manner that would limit the scope of this invention.

### List of embodiments:

1. Multi-layered backsheet for solar modules comprising in this order
   (i) an optional top layer (layer (i)),
   (ii) an insulating layer (layer (ii)),
   (iii) a back layer (layer (iii)),
   wherein between each layer there are no sublayers, wherein the top layer (i), the insulating layer (ii) and the back layer (iii) contain a polyolefin as the major component, wherein the polyolefin is selected from polyethene homo- and copolymers (PE's) as defined in the claims
2. The backsheet of 1 wherein the insulating (ii) has a thickness of at least 210 or at least 310 µm.
3. The backsheet of either one of 1 or 2 wherein at least the layers (ii) and (iii) and preferably also layer (i) contain independently from each other as the major component a polyethene selected from LLDPE, LDPE, MDPE, HDPE, or a combination thereof.
4. The backsheet of any one of 1 to 3 having a dielectric breakdown voltage of at least 20 kV.
5. The backsheet of any one of 1 to 4 having a thickness of at least 0 25 and up to 0.7 mm
6. The backsheet of any one of 1 to 5 wherein the layer (i) contains pigments, preferably white pigments.
7. The backsheet of any one of 1 to 6 wherein the layer (ii) is free of pigments and/or carbon particles
8. The backsheet of any one of 1 to 7 wherein layer (iii) contains carbon particles.
9. The backsheet of any one 1 to 8 wherein the layer (iii) has a thickness of between 50 and 130µm.
10. The backsheet of any one of 1 to 9 wherein the polymers in layers (i) or (ii) or (iii), or (i) and (ii), or (ii) and (iii), or (i), (ii) and (iii) are cross-linked, by physical cross-linking with e-beam-, gamma or beta irradiation.
11. The backsheet of any one of 1 to 10 wherein the layers (i) and (ii), and/or (ii) and (iii) are cross-linked with each other.
12. The backsheet according to any one of 1 to 11 wherein the layers (ii) or (iii) or (ii) and (iii) contain flame retardants and/or anti dripping agents
13. The backsheet of any one of 1 to 12 having a reduction of dielectric break drown voltage of less than 1% and a reduction in elongation at break and tensile strength of less then 20% after being exposed to steam at a temperature of 121 °C and a pressure of 1 bar for 100 hours
14. A solar module comprising one or more solar cells and one or more encapsulating layer and further comprising a backsheet according to any one of 1 to 13.
15. The solar module of embodiment 14 being a crystalline solar module.
16. The solar module of any one of 14 to 15 wherein the encapsulating layer comprises EVA.
17. A method of making a backsheet according to any one of 1 to 13 said method comprising
   providing compositions for making layers (i), (ii) and (iii)
   coextruding the compositions into layers,
   wherein the coextruded layers are subjected to cross-linking.
18. Method of making a solar module comprising vacuum laminating the backsheet of any one of 1 to 13 to an encapsulating layer of a solar module

### Examples:

### Materials:

- Hostalen HD 9550 F:: high density polyethylene (0,95 g/cm³) Lyondell Basell Industries Holdings B.V., Rotterdam, The Netherlands.
- Lupolen 3020 K:: low density polyethylene (0,927 g/cm³), Lyondell Basell Industries Holdings B.V., Rotterdam, The Netherlands.
- Polybatch UV 1952:: stabilizer masterbatch, containing 10 % of a hindered amine light stabilizer, A.Schulman GmbH, Kerpen, Germany
- Polywhite NG 8270 W:: white masterbatch, containing 60% titanium dioxide (rutile), in polyethylene, A.Schulman GmbH, Kerpen, Germany
- Polyblack 1423,: black masterbatch, containing 40% carbon black in polyethylene, A.Schulman GmbH, Kerpen, Germany.
- Polybatch PR 1049 DC: masterbatch containing flame retardants (halogenated organics), A. Schulman, Kerpen, Germany

### Example 1

A three layer polyethylene backsheet was prepared by first preparing the compositions for the individual layers. The top layer composition (layer (i)) was prepared by blending 2,000 g of Polywhite NG 8270 W with 7,500 g of Hostalen HD 9550 F and with 500 g of Polybatch UV 1952 in a tumble mixer at room temperature.

The composition for the back layer (layer iii) was prepared by blending 1,000 g of Polyblack 1423 with 8,500 g Hostalen HD 9550 F and with 500 g of Polybatch UV 1952 in a tumble mixer at room temperature.

The composition of the middle layer (layer (ii) was prepared by blending 9,500 g Lupolen 3020K with 500 g of Polybatch UV 1952 in a tumble mixer at room temperature.

To produce three-layered coextruded samples a coating line with 3 extruders was used. The white (solar facing) layer (i) was metered by a KTron Gravimetric Feeder, commercially available from KTron, Germany, into a twin screw extruder, commercially available from Werner & Pfleiderer, Germany, with a screw diameter of 25 mm and a length of 45 times the screw diameter. The middle layer (ii) was melted with a single screw extruder commercially available from Plastik Maschinenbau, Germany with a screw diameter of 45 mm and a length of 30 times the screw diameter. The black (backside facing) layer (iii) was melted with a single screw extruder commercially available from Extrudex, USA with a screw diameter of 30 mm and a length of 30 times the screw diameter.

All 3 extruders fed the polymers into a Cloeren 3-layer-feed block to feed the molten stream into the positions i-ii-iii in the final melt stream. The melt stream was fed through a slot die, commercially available from EDI. The coextruded examples were made while casting from a slot die directly onto a chilled stainless steel roll without significant draw. The cooled layers were wound into a roll.

After extrusion the three-layer product was subjected to e-beam radiation to cross-link the material using an e-beam unit commercially available from Polymer Physics, using 295 kV with a beam current of 4 mA. The samples were treated 4 times. A 50 cm x 20 cm wide sample was cut from the sheet for further testing.

The material of example 1 was compared with other materials:
C1: A backsheet containing polyamide layers (Icosolar AAA 3554, Isovolta AG, Wiener Neudorf, Austria);
C2: A backsheet comprising a PET/PET/EVA composition (DYMAT PYE, Coveme, San Lazzaro di Savena, Italy);
C3: A backsheet containing a PVF/PET/PVF composition (Icosolar 2442, Isolvolta AG);
C4: A backsheet containing a PVF/PET/PVF composition (AKASOL PTL 3HR 700V, Krempel, Vaihingen/Enz, Germany).

The materials were subjected to a pressure cook test DIN EN 60749-33 to test their hydrolytic stability and ageing properties. Test conditions were cooking the materials at 121 °C at 1 bar pressure for 100 hours in presence of steam.
The mechanical and electrical properties of the materials were tested before and after the pressure cook test.

The dielectric breakdown voltage was determined according to ASTM D149.
The tensile strength and elongation at break were determined according to ASTM D-882 on a tensile tester, commercially available from Zwick, Germany.

The mechanical properties of the materials before the pressure cook test were as indicated in table 1 and compared with the properties after the pressure cook test as indicated in table 2. Table 2 also indicates the degree of deterioration (expressed as reduction in %) of the property before and after the test.

**Table 1: properties before pressure cooking test**

| | C1 | C2 | C3 | C4 | Ex 1 |
|---|---|---|---|---|---|
| Thickness [µm] | 370 | 300 | 300 | 370 | 450 |
| Dielectric Breakdown Voltage [kV] | 18.5 | 21.3 | 22.0 | 22.4 | 22.9 |
| Tensile [MPa] | 28.1 | 87.0 | 91.8 | 97.0 | 29.3 |
| Elongation at break [%] | 270.0 | 77.9 | 96.7 | 98.5 | 328.2 |

**Table 2: properties after pressure cooking test and degree of deterioration (reduction in original properties).**

| | C1 | C2 | C3 | C4 | Ex 1 |
|---|---|---|---|---|---|
| Appearance | Intact | Complete delamination | intact | Partial delamination | Intact |
| Reduction in Dielectric Breakdown | 0% | - | ca 5% | ca 10% | 0% |
| Tensile [MPa] | 26.7 | - | 12.7 | 5.5 | 24.1 |
| (Reduction) | (5%) | | (86%) | (94%) | (18%) |
| Elongation at break [%] | 30.3 | - | 18.1 | <1 | 295.0 |
| (Reduction) | (89%) | | (81%) | (99%) | (10%) |

### Examples 2 to 4:

Example 1 was repeated but using various amounts of flame retardant (Polybatch PR 1049 DC).
In example 2 the flame retardant was added to layer (ii) by 15 % by weight. The resulting backsheet had a break down voltage of 23.18 kV.
In example 3 the flame retardant was added to layer (ii) by 30% by weight. The resuting backsheet had a break down voltage of 23.64 kV.
In example 4 example 3 was repeated by also adding the flame retardant by 30% by weight to layer (iii). The resulting backsheet had a breakdown voltage of 24.80 kV.

## Claims

1. Multi-layered backsheet for solar modules comprising in this order
(i) an optional top layer (layer (i)),
(ii) an insulating layer (layer (ii)),
(iii) a back layer (layer (iii)),
wherein the top layer (i), the insulating layer (ii) and the back layer (iii) contain a polyolefin as the major component, wherein the polyolefin is selected from polyethene homo- and copolymers, wherein the polyethene copolymers contain more than 50 mole % of units derived from ethene and contain alpha-olefin comonomers and wherein the layers (i) and (ii), or (ii) and (iii), or (i), (ii) and (iii) are coextruded and wherein the polymers in layers (i), (ii) and (iii) are cross-linked, and wherein the backsheet does not contain any layers between layers (i) and (ii), layers (ii) and (iii) or between layers (i), (ii) and (iii).

2. The backsheet of claim 1 wherein at least the layers (ii) and (iii) and preferably also layer (i) contain independently from each other as the major component a polyethene homopolymer or copolymer containing more than 90 mole % of units derived from ethane and containing alpha-olefin comonomers.

3. The backsheet of either one of claims 1 or 2 wherein at least the layers (ii) and (iii) and preferably also layer (i) contain independently from each other as the major component a polyethene selected from LLDPE, LDPE, MDPE, HDPE, or a combination thereof.

4. The backsheet of any one of claims 1 to 3 having a dielectric breakdown voltage of at least 20 kV.

5. The backsheet of any one of claims 1 to 4 having a thickness of at least 0.25 mm and up to 0.7 mm.

6. The backsheet of any one of claims 1 to 5 wherein the layer (ii) contains no pigments.

7. The backsheet of any one of claims 1 to 6 wherein layer (iii) contains carbon particles.

8. The backsheet of any one of claims 1 to 7 having a reduction of dielectric break down voltage of less than 1% and a reduction in elongation at break and tensile strength of less then 20% after being exposed to steam at a temperature of 121 °C and a pressure of 1 bar for 100 hours.

9. The backsheet according to any one of claims 1 to 8 wherein the layers (ii) or (iii) or (ii) and (iii) contain flame retardants, anti dripping agents or both.

10. A solar module comprising one or more solar cells and one or more encapsulating layer and further comprising a backsheet according to any one of claims 1 to 8.

11. A method of making a backsheet according to any one of claims 1 to 8 said method comprising
providing compositions for making layers (i), (ii) and (iii)
coextruding the compositions into a multi-layered article and cross-linking.

12. Method of making a solar module comprising vacuum laminating the backsheet of any one of claims 1 to 8 to a solar module.

## Patentansprüche

1. Mehrschichtige Rückseitenfolie für Solarmodule, umfassend in dieser Reihenfolge
(i) eine fakultative Deckschicht (Schicht (i)),
(ii) eine Isolierschicht (Schicht (ii)),
(iii) eine Rückschicht (Schicht (iii)),
wobei die Deckschicht (i), die Isolierschicht (ii) und die Rückschicht (iii) als Hauptkomponente ein Polyolefin enthalten, wobei das Polyolefin aus Polyethen-Homopolymeren und -Copolymeren ausgewählt ist, wobei die Polyethen-Copolymere mehr als 50 Mol-% von Ethen abgeleitete Einheiten enthalten und alpha-Olefin-Comonomere enthalten, und wobei die Schichten (i) und (ii) oder (ii) und (iii) oder (i), (ii) und (iii) coextrudiert sind und wobei die Polymere in den Schichten (i), (ii) und (iii) vernetzt sind und wobei die Rückseitenfolie keine Schichten zwischen den Schichten (i) und (ii), den Schichten (ii) und (iii) oder den Schichten (i), (ii) und (iii) enthält.

2. Rückseitenfolie nach Anspruch 1, wobei mindestens die Schichten (ii) und (iii) und vorzugsweise auch Schicht (i) unabhängig voneinander als Hauptkomponente ein Polyethylen-Homopolymer oder -Copolymer mit mehr als 90 Mol-% von Ethen abgeleiteten Einheiten und alpha-Olefin-Comonomeren enthalten.

3. Rückseitenfolie nach Anspruch 1 oder 2, wobei mindestens die Schichten (ii) und (iii) und vorzugsweise auch Schicht (i) unabhängig voneinander als Hauptkomponente ein aus LLDPE, LDPE, MDPE, HDPE oder einer Kombination davon ausgewähltes Polyethylen enthalten.

4. Rückseitenfolie nach einem der Ansprüche 1 bis 3 mit einer dielektrischen Durchschlagsspannung von mindestens 20 kV.

5. Rückseitenfolie nach einem der Ansprüche 1 bis 4 mit einer Dicke von mindestens 0,25 mm und bis zu 0,7 mm.

6. Rückseitenfolie nach einem der Ansprüche 1 bis 5, wobei die Schicht (ii) keine Pigmente enthält.

7. Rückseitenfolie nach einem der Ansprüche 1 bis 6, wobei die Schicht (iii) Kohlenstoffteilchen enthält.

8. Rückseitenfolie nach einem der Ansprüche 1 bis 7 mit einer Verringerung der dielektrischen Durchschlagsspannung von weniger als 1% und einer Verringerung der Reißdehnung und Zugfestigkeit von weniger als 20% nach Einwirkung von Wasserdampf bei einer Temperatur von 121°C und einem Druck von 1 bar über einen Zeitraum von 100 Stunden.

9. Rückseitenfolie nach einem der Ansprüche 1 bis 8, wobei die Schichten (ii) oder (iii) oder (ii) und (iii) Flammschutzmittel und/oder Antitropfmittel enthalten.

10. Solarmodul mit einer oder mehreren Solarzellen und einer oder mehreren Einkapselungsschichten sowie einer Rückseitenfolie nach einem der Ansprüche 1 bis 8.

11. Verfahren zur Herstellung einer Rückseitenfolie nach einem der Ansprüche 1 bis 8, bei dem man
Zusammensetzungen zur Herstellung der Schichten (i), (ii) und (iii) bereitstellt,
die Zusammensetzungen zu einem mehrschichtigen Gegenstand coextrudiert und vernetzt.

12. Verfahren zur Herstellung eines Solarmoduls, bei dem man die Rückseitenfolie nach einem der Ansprüche 1 bis 8 auf ein Solarmodul vakuumlaminiert.

## Revendications

1. Feuille arrière multicouche pour modules solaires comprenant dans cet ordre
(i) une couche supérieure facultative (couche (i)),
(ii) une couche isolante (couche (ii)),
(iii) une couche arrière (couche (iii)),
la couche supérieure (i), la couche isolante (ii) et la couche arrière (iii) contenant une polyoléfine comme principal composant, la polyoléfine étant choisie parmi les homo- et copolymères de polyéthylène, les copolymères de polyéthylène contenant plus de 50 % en moles de motifs dérivés de l'éthylène et contenant des comonomères alpha-oléfiniques, les couches (i) et (ii), ou (ii) et (iii), ou (i), (ii) et (iii) étant coextrudées, les polymères dans les couches (i), (ii) et (iii) étant réticulés, et la feuille arrière ne contenant aucune couche entre les couches (i) et (ii), entre les couches (ii) et (iii) ou entre les couches (i), (ii) et (iii).

2. Feuille arrière selon la revendication 1 dans laquelle au moins les couches (ii) et (iii) et de préférence également la couche (i) contiennent indépendamment les unes des autres, comme principal composant, un homopolymère ou copolymère de polyéthylène contenant plus de 90 % en moles de motifs dérivés de l'éthane et contenant des comonomères alpha-oléfiniques.

3. Feuille arrière selon l'une ou l'autre des revendications 1 et 2 dans laquelle au moins les couches (ii) et (iii) et de préférence également la couche (i) contiennent indépendamment les unes des autres, comme principal composant, un polyéthylène choisi parmi le LLDPE, le LDPE, le MDPE, le HDPE, et leurs combinaisons.

4. Feuille arrière selon l'une quelconque des revendications 1 à 3 ayant une tension de claquage d'au moins 20 kV.

5. Feuille arrière selon l'une quelconque des revendications 1 à 4 ayant une épaisseur d'au moins 0,25 mm et d'au plus 0,7 mm.

6. Feuille arrière selon l'une quelconque des revendications 1 à 5 dans laquelle la couche (ii) ne contient pas de pigments.

7. Feuille arrière selon l'une quelconque des revendications 1 à 6 dans laquelle la couche (iii) contient des particules de carbone.

8. Feuille arrière selon l'une quelconque des revendications 1 à 7 présentant une réduction de la tension de claquage de moins de 1 % et une réduction de l'allongement à la rupture et de la résistance à la traction de moins de 20 % après avoir été exposée à de la vapeur d'eau à une température de 121 °C et une pression de 1 bar pendant 100 heures.

9. Feuille arrière selon l'une quelconque des revendications 1 à 8 dans laquelle les couches (ii) ou (iii) ou (ii) et (iii) contiennent des ignifugeants, des agents anti-égouttement, ou les deux.

10. Module solaire comprenant une ou plusieurs cellules solaires et une ou plusieurs couches d'encapsulation, et comprenant également une feuille arrière selon l'une quelconque des revendications 1 à 8.

11. Procédé de fabrication d'une feuille arrière selon l'une quelconque des revendications 1 à 8, ledit procédé comprenant
l'obtention de compositions pour fabriquer les couches (i), (ii) et (iii),
la coextrusion des compositions en un article multicouche et leur réticulation.

12. Procédé de fabrication d'un module solaire comprenant le laminage sous vide de la feuille arrière selon l'une quelconque des revendications 1 à 8 sur un module solaire.
